# EUROPEAN PATENT SPECIFICATION

(11) **EP 0 848 395 B1**
(45) Date of publication and mention of the grant of the patent: **03.03.2004**
(21) Application number: 97660137.7
(22) Date of filing: 02.12.1997
(51) Int. Cl.: H01F 38/30, G01R 15/14, G01R 1/20

(54) **Current-meter transformer provided with a current divider**
Mit einem Stromteiler versehener Transformator zur Strommessung
Transformateur de mesure des courants muni d'un diviseur de courant

(30) Priority: 11.12.1996 FI 964948
(43) Date of publication of application: 17.06.1998
(73) Proprietor: ENERMET OY, SF-40420 Jyskä (FI)
(72) Inventor: Hirsimäki, Olavi, 40420 Jyskä (FI); Pietikäinen, Ville, 40340 Jyväskylä (FI); Lahti, Teuvo, 40100 Jyväskylä (FI); Korkolainen, Tuomo, 40500 Jyväskylä (FI)
(74) Representative: Stellberg, Hans

(56) References cited:
- EP-A- 0 111 063
- EP-A- 0 670 498
- DE-A- 19 535 551
- GB-A- 2 135 831
- US-A- 5 400 006
- MILKOVIC M: "SPLIT-CONDUCTOR CURRENT SENSORS WITH ELECTRONIC LOAD TERMINATION" IEEE TRANSACTIONS ON INSTRUMENTATION AND MEASUREMENT, vol. 41, no. 4, 1 August 1992, pages 540-547, XP000310265

## Description

The invention concerns a current-meter transformer according to the preamble of the claim.

A transformer that is used for a metering purpose must operate free of errors also in an external magnetic field. The requirements concerning toleration of an external magnetic field ruled in international standards have become considerably stricter in recent years.

A mode known from the prior art for eliminating the effect of an external magnetic field in a transformer is to provide the transformer with two secondary windings which are placed symmetrically at opposite sides of the transformer core. The magnetic flux produced by the primary conductor, which flux is supposed to be metered, passes through these windings in opposite directions. The external magnetic field passes through both windings in the same direction. When the secondary windings are connected in series in a suitable way, the effect of the external magnetic field is neutralized.

It is a drawback of this prior-art solution that a strong current flows through the primary conductor, for which reason a relatively large transformer is required. Further, in this prior-art solution, the capability of toleration of a DC component is poor.

With respect to the prior art, reference is made to the publications **DE 27 34 729, DE 30 08 308,** and **US 4,240,059.** In the prior-art current transformers of this type which are provided with a current divider, the current to be metered is divided into two parts, of which one part flows through the transformer. In this way the transformer can be made to operate at low flux density values and, thus, the transformer is not saturated even at high current intensities. Thus, the range of metering of the transformer can be made wider.

In the prior-art current transformers, attempts have been made to dimension the shape of the current divider so that the heating of the current divider caused by the metering current should be as uniform as possible in the branch of the current divider passing through the transformer and in the branch by-passing the transformer. The publications **EP 0,111,063, US 4,240,059, DE 27 34 729,** and **EP 0,123,062** expressly deal with compensation of heating. In said cited papers, the concentration has been almost exclusively on achieving a uniform heating of the current divider. In such a case, the resistances of the branches of the current divider are changed relatively to an equal extent, and the current dividing ratio remains invariable in spite of heating of the current divider.

Owing to non-ideal properties of the current transformer, a phase difference arises between the primary current and the secondary current in the current transformer. This phase difference is quite detrimental in particular when the current transformer is used in applications of metering of electric energy. The phase error thus produced by the current transformer is detrimental in particular because it is not of invariable magnitude, but its magnitude depends on the intensity of the current passing through the current transformer. This phenomenon comes from non-linear magnetizing of the transformer iron. The relative permeability of the transformer iron increases when the magnetic flux density in the transformer iron increases.

In the prior art, attempts have been made to correct the phase error in a current-meter transformer by carrying out the correction as of invariable magnitude over the entire range of metering current. With such a solution, the phase error in the current-meter transformer can be made equal to zero at one point only. Elsewhere in the range of metering current, a positive phase error and a negative phase error, respectively, still occur.

A current transformer provided with a current divider, corresponding to the prior art described above, is also described in the FI Patent 78,794. In current transformers of this type, which are provided with a current divider, the current to be metered is divided into two parts, of which one part passes through the transformer. In this way the transformer can be made to operate at low flux density values, and the transformer is not saturated even at high current intensities. Owing to this, the range of current of the transformer can be made wider.

A current transformer that is used in a meter of electric energy must also tolerate a DC component passing in the primary conductor without being saturated. In order to meet this requirement, the primary conductor has been made so that just a part of the current to be metered passes through the current transformer. In the prior-art current transformers provided with a current divider, there is one branch that passes through the transformer and one by-pass branch. In the prior-art current transformers, the secondary circuit consists of one winding.

The article "split-Conductor Current Sensors with Electronic Load Termination" in IEEE Transactions on Instrumentation and Measurement 41(1992) August, No. 4, New York by Miran Milkovic discloses a current transformer using a primary conductor comprising a primary conductor part and two by-pass parts. The primary conductor part passes through the space enclosed by the magnetic core of the transformer. The by-pass parts are electrically symmetric and pass on opposite sides outside the magnetic core. The primary conductor is formed of a rectangular blank having two rectangular windows. The magnetic core passes through said windows. The primary conductor part is thus formed between said windows. The secondary winding on the magnetic core is asymmetric resulting in a current transformer that is sensitive to an external field.

It is the greatest advantage of a current transformer provided with a current divider that a current of low strength passes through the current transformer, owing to which the size of the transformer can be made small. It is the most important drawback of this prior-art solution that the toleration of an external magnetic field is deteriorated to a considerable extent.

The object of the present invention is to provide an improvement over the prior-art current transformers provided with a current divider. It is a more specific object of the invention to provide a current transformer that is considerably more tolerant in relation to external magnetic fields, as compared with the prior-art solutions.

The objectives of the invention are achieved by means of a current transformer which is defined in the characterizing clause of the claim.

In the present invention, it has been realized to form the by-pass part of the current divider electrically symmetric. Further, in the invention, the magnetic circuit of the current transformer has been formed symmetric in relation to an external magnetic field, in which case, in the solution of the present invention, it has been possible to maintain the prior-art mode, described above, of elimination of the effect of an external magnetic field.

In a preferred embodiment of the invention, the primary-conductor part of the current transformer is placed symmetrically in relation to the magnetic circuit of the current transformer.

In some preferred embodiments of the invention, there are at least two by-pass branches in the current divider and at least one primary-conductor branch.

The invention will be described in detail with reference to a preferred embodiment of the invention illustrated in the figures in the accompanying drawings, the invention being, however, not supposed to be confined to said embodiment alone.

Figure 1 is an axonometric view of a prior-art current-meter transformer.

Figure 2 is an axonometric view of a second prior-art current-meter transformer provided with a current divider.

Figure 3 is an axonometric view of a preferred embodiment of a current-meter transformer in accordance with the invention provided with a current divider.

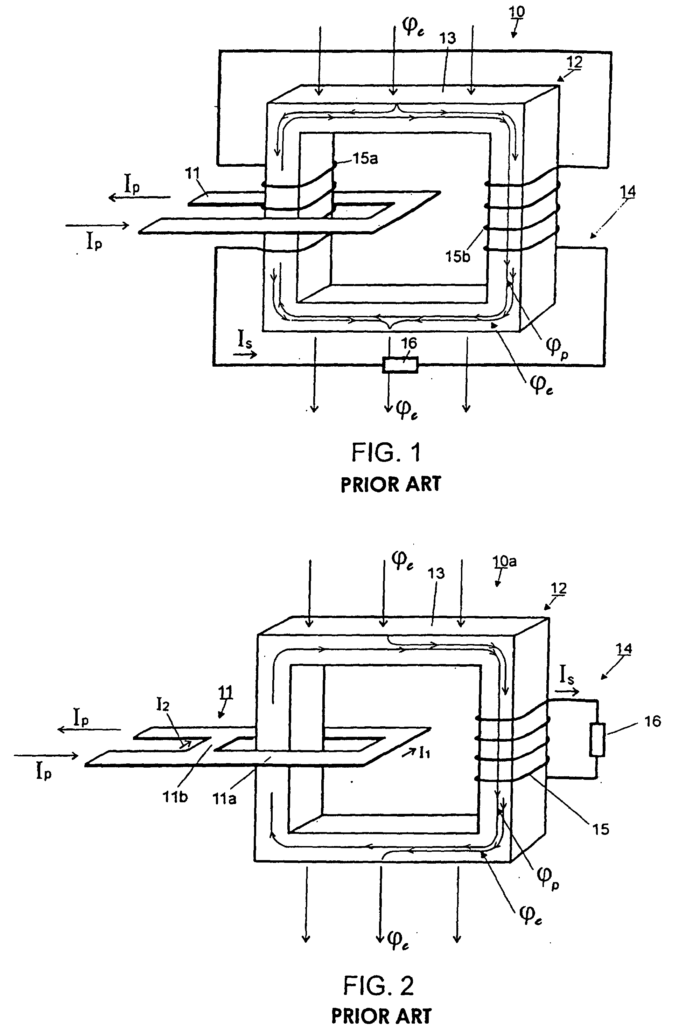

The prior-art current-meter transformer shown in Fig. 1 is denoted generally with the reference numeral 10. The primary conductor is denoted with the reference numeral 11 and the current transformer with the reference numeral 12. The core of the current transformer 12 is denoted with the reference numeral 13. The current flowing in the primary conductor 11 is denoted with the letter Iₚ. The secondary circuit of the current transformer 12 is denoted generally with the reference numeral 14. The current that flows in the secondary circuit 14 is denoted with the letter Iₛ. In this prior-art solution, the effect of the external magnetic field φₑ has been eliminated by providing the transformer with two secondary windings 15a and 15b, which are placed symmetrically at opposite sides of the core 13. The reference numeral 16 denotes the resistor. Thus, the secondary windings 15a and 15b are connected in series, in which case the effect of the external magnetic field φₑ is compensated. The magnetic flux induced by the primary conductor 11 is denoted with the letter φₚ.

The prior-art current-meter transformer provided with a current divider that is shown in Fig. 2 is denoted generally with the reference numeral 10a. The current divider consists of a conductor 11, in whose first branch, i.e. in the primary-conductor branch 11a, the current I₁ flows, and in whose second branch, i.e. in the by-pass branch 11b, the current I₂ flows. The core of the current transformer 12 is denoted with the reference numeral 13, and the secondary circuit with the reference numeral 14. The current Iₛ flows in the secondary circuit 14. The winding in the secondary circuit 14 is denoted with the reference numeral 15, and the resistor with the numeral 16.

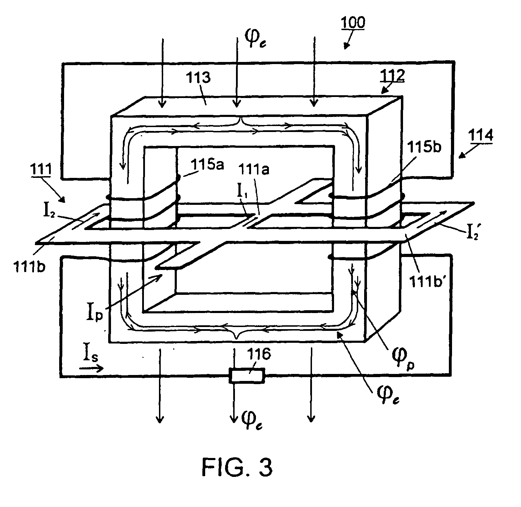

In Fig. 3, the current-meter transformer in accordance with the invention is denoted generally with the reference numeral 100. The current divider is denoted generally with the reference numeral 111, the current transformer with the reference numeral 112, and the secondary circuit with the reference numeral 114. The core of the current transformer 112 is denoted with the reference numeral 113.

In accordance with the basic realization of the invention, the by-pass part 111b and 111b' of the current divider 111 has been formed electrically symmetric. Further, the magnetic circuit of the current-meter transformer 100 has been formed symmetric in relation to the external magnetic field φₑ in a way similar to that in Fig. 1. The windings in the secondary circuit 114 are denoted with the reference numerals 115a and 115b, and the resistor with the reference numeral 116.

In the embodiment as shown in Fig. 3, the by-pass part of the current divider 111 consists of two branches 111b and 111b'. Of course, the by-pass part can also consist of more than two branches. In this embodiment, the primary-conductor part 111a of the current divider 111 consists of one flow branch. Of course, there may be more than one flow branches 111a. The current flowing in the primary-conductor branch 111a is denoted with the letter I₁, and the currents flowing in the by-pass branches 111b and 111b' with the letters I₂ and I₂', respectively. In principle, the by-pass part may also consist of one electrically symmetric branch.

In the embodiment in accordance with Fig. 3, the primary-conductor part 111a is placed symmetrically in relation to the magnetic circuit of the current-meter transformer 100. This is an advantageous mode of location, but not entirely necessary.

Above, just the solution of principle of the invention has been described, and it is obvious to a person skilled in the art that numerous modifications can be made to said solution within the scope of the inventive idea disclosed in the accompanying patent claims.

## Claims

1. A current-meter transformer (100) comprising a primary conductor (111) and a magnetic circuit (112), said magnetic circuit (112) comprising a magnetic core (113) enclosing a space and a secondary circuit (114), said primary conductor (111) being a current divider comprising a primary-conductor part (111a) and two by-pass parts (111b, 111b'), said primary conductor part (111a) passing through the space enclosed by the core (113) from a front to a back of the magnetic core (113), said by-pass parts (111b, 111b') being electrically symmetric and passing on opposite sides outside the magnetic core (113) from the front to the back of the magnetic core (113), said primary-conductor part (111a) and said by-pass parts (111b, 111b') being connected on the front and the back of the magnetic core (113), **characterised in that** said secondary circuit (114) comprises two secondary windings (115a, 115b) being placed symmetrically at opposite sides of the core (113) and being connected in series and that the primary-conductor part (111a) of the current divider (111) is placed symmetrically in relation to the magnetic circuit of the current-meter transformer (100), said current-meter transformer being thereby insensitive to an external magnetic field (φₑ).

## Patentansprüche

1. Ein Transformator zur Strommessung (100) weist einen primären Leiter (111) und einen magnetischen Schaltkreis (112), wobei der magnetische Schaltkreis (112) einen magnetischen Kern (113) aufweist, welcher einen Raum einschließt und einen sekundären Schaltkreis (114) auf, wobei der primäre Leiter (111) ein Stromteiler ist, welcher ein Primär-Leiterteil (111a) und zwei Bypassteile (111b, 111b') aufweist, wobei das Primärleiterteil (111a) durch den Raum, der vom Kern (113) eingeschlossen ist von einem vorderen zu einem hinteren Bereich des magnetischen Kerns (113) führt, wobei die Bypassteile (111b, 111b') elektrisch symmetrisch sind und auf gegenüberliegenden Seiten außerhalb des magnetischen Kerns (113) von dem vorderen zu dem hinteren Bereich des magnetischen Kerns (113) vorbei führen, wobei das Primär-Leiterteil (111a) und die Bypassteile (111b, 111b') im vorderen und im hinteren Bereich des magnetischen Kerns (113) verbunden sind, **dadurch gekennzeichnet, dass** der sekundäre Schaltkreis (114) zwei sekundäre Wicklungen (115a, 115b) aufweist, welche symmetrisch auf gegenüberliegenden Seiten des Kerns (113) angeordnet sind und in Serie geschaltet sind, und dass das Primär-Leiterteil (111a) des Stromteilers (111) symmetrisch in Beziehung zu dem magnetischen Schaltkreis des Transformators zur Strommessung (100) angeordnet sind, wodurch der Transformator zur Strommessung unempfindlich gegenüber einem externen Magnetfeld (Φₑ) ist.

## Revendications

1. Transformateur de mesure de courant (100) comprenant un conducteur primaire (111) et un circuit magnétique (112), ledit circuit magnétique (112) comprenant un noyau magnétique (113) renfermant un espace et un circuit secondaire (114), ledit conducteur primaire (111) étant un diviseur de courant comprenant une partie de conducteur primaire (111a) et deux parties de dérivation (111b,111b'), ladite partie de conducteur primaire (111a) traversant l'espace défini par le noyau (113) de l'avant à l'arrière du noyau magnétique (113), lesdites parties de dérivation (111b,111b') étant symétriquement électriques et passant sur des côtés opposés à l'extérieur du noyau magnétique (113) de l'avant à l'arrière du noyau magnétique (113), ladite partie de conducteur primaire (111a) et lesdites parties de dérivation (111b,111b') étant raccordées sur l'avant et sur l'arrière du noyau magnétique (113), **caractérisé en ce que** ledit circuit secondaire (114) comprend deux enroulements secondaires (115a,115b) placés symétriquement sur les côtés opposés du noyau (113) et étant montés en série et **en ce que** la partie de conducteur primaire (11a) du diviseur de courant (111) est placée symétriquement par rapport au circuit magnétique du transformateur de mesure de courant (100), ledit transformateur de mesure de courant étant ainsi insensible à un champ magnétique extérieur (φₑ).
